Europäisches Patentamt

European Patent Office

Office européen des brevets

(11) Publication number: **0 457 339 A2**

## EUROPEAN PATENT APPLICATION

(21) Application number: **91107991.1**

(22) Date of filing: **17.05.91**

(51) Int. Cl.5: **H05K 3/16, C23C 14/34, H01J 37/34, H05K 3/24, C25D 5/18, C25D 5/54**

(30) Priority: **18.05.90 FI 902463**

(43) Date of publication of application:
**21.11.91 Bulletin 91/47**

(84) Designated Contracting States:
**AT BE CH DE DK ES FR GB GR IT LI LU NL SE**

(71) Applicant: **SORLET FINLAND OY**
**Harjutie 16**
**SF-15560 Nastola(FI)**

(72) Inventor: **Saarinen, Erkki**
**Merisotilaantori 3 B 10**
**SF-00160 Helsinki(FI)**

(74) Representative: **Pellmann, Hans-Bernd,**
**Dipl.-Ing. et al**
**Patentanwaltsbüro**
**Tiedtke-Bühling-Kinne-Grupe-Pellmann-Gra-**
**ms, Bavariaring 4**
**W-8000 München 2(DE)**

(54) Method and apparatus for the production of circuit boards.

(57) The invention relates to a method of producing circuit boards by utilizing a magnetron sputtering method, in which a circuit board (23) is placed in a chamber (2) to which a magnet-cathode-anode unit (3) is attached, vacuum is created in the chamber and inert gas is introduced into it and a plasma cloud is formed in it by means of an electric and magnetic field, whereby metal atoms break away from the cathode (30) and deposit on the surface of the circuit board (23). In order that the coating process would be technically easy and provide a good coating result, the method of the invention is mainly characterized in that the circuit board (23) is kept at a pressure of 0.015 to 0.1 mb at a distance of 5 to 70 mm from the cathode (30) of the magnet-cathode-anode unit during the plasma coating, whereafter the circuit board (23) is coated galvanically by a pulse galvanization technique. The invention is also concerned with a vacuum chamber unit for use in the production of circuit boards.

FIG. 1

The invention relates to a method of producing a circuit board by utilizing a magnetron sputtering technique, in which a circuit board is placed in a chamber to which a magnet-cathode-anode unit is attached, vacuum is created in the chamber and inert gas is introduced into it and a plasma cloud is formed in it by means of an electric and magnetic field, whereby metal atoms break away from the cathode and deposit on the surface of the circuit board.

The invention is also concerned with a vacuum chamber unit for use in the production of circuit boards by utilizing a magnetron sputtering technique, the vacuum chamber unit comprising a vacuum chamber to which two magnet-cathode-anode units are attached detachably.

Circuit boards used in the electronic industry are conventionally produced by immersing a circuit board blank made of an insulating material and containing glass fibres in a bath containing copper ions so as to coat the blank with a copper layer. The problem therewith is that the method cannot provide an even copper layer having a thickness smaller than about 15 $\mu$m. In particular, it is difficult and slow to make the coating material to enter the holes of the circuit board. In addition, the method is slow as it comprises several bath treatments, and it contaminates the environment. In the early 80's, attempts were made to solve these problems by utilizing vacuum technique and plasma in the production of circuit boards. The operational principle in plasma coating is to create a plasma cloud under vacuum, the plasma cloud containing atoms of the coating material which are deposited on to the surface of the circuit board to be coated. The shape of the plasma cloud can be affected and the coating result improved by connecting a magnetic field to the plasma coating equipment. This method, called magnetron sputtering, has been applied in the production of circuit boards for a few years; the results, however, have not been promising: the method has been applied with a complicated equipment, in addition to which the method has been slower than expected and the resulting coating has frequently been poor. The coating costs have been higher than expected, and the method has not gained any greater popularity amongst the circuit board manufacturers. When applying magnetron sputtering in the production of circuit boards, it has been customary to dispose the circuit board to be coated in a cylindrical coating chamber or in a coating chamber of other similar shape, in which a vacuum as complete as possible is created, a pressure of about $10^{-6}$ mb being applied. Thereafter argon gas is introduced into the coating or vacuum chamber, and an electric and magnetic field is created so as to cause the argon atoms to bombard the surface of a cathode or a target under vacuum, as a result of which copper atoms and molecules are detached from the target and carried on to the surface of the circuit board under the influence of the vacuum. It has been found out that a pressure below 0.005 mb is required for the argon and copper atoms and molecules to be able to pass sufficiently efficiently towards the circuit board to be coated in the vacuum chamber. The creation of a very low pressure sets high requirements on the vacuum chamber unit with its auxiliary apparatuses (vacuum pumps, etc), in addition to which such a vacuum is slow to create: it often takes a couple of hours to get the prior art equipment ready for operation. It is typical of the problematic nature and slowness of the creation of extremely low pressures that when the pressure is decreased e.g. by one half (from a given vacuum value), the time required for creating the vacuum becomes many times longer. A further problem is that the prior art circuit boards, typically made of glass fibre, emit gases and impurities under vacuum, which both slow down the deposition of copper atoms on to the surface of the circuit board and impair the coating result. In order to coat both sides of the circuit board, it has been necessary to turn the circuit board. To sum up, the applications of the magnetron sputtering method, most of them laboratory applications, have not previously been successful enough to result in a general use of the method in the mass production of circuit boards. In practice, the growing of a thin sputtered electrically conductive layer, e.g. galvanically (conventional galvanic coating after plasma treatment is a prior art technique), to form a conductive layer of desired thickness has proved very difficult if not impossible in cases where the circuit board is not small in size. Small circuit boards, e.g. 40 x 40 mm, are coated in a conventional galvanic DC treatment. Circuit boards larger than that cannot be coated in this way because their middle portion will not be coated as the solutions used in galvanic baths dissolve the sputtered layer from the middle portion of the circuit board before the galvanic growing process has been started.

The object of the method of the invention is to avoid the problems associated with the methods known from the prior art, which method is mainly characterized in that the circuit board disposed in the chamber is kept at a pressure of 0.015 to 0.1 mb at a distance of 5 to 70 mm from the cathode of the magnet-cathode-anode unit during the plasma coating, whereafter the circuit board is coated galvanically by a pulse galvanization technique at a current density of 40 to 80 A per one square decimetre of the circuit board, and pulse-width modulation is applied at a pulse density of 500 Hz to 10 kHz, and a modulation frequency of 10 to 50 Hz is applied for 20 to 80 seconds, whereby the pulse width is varied during the pulse-width modulation between 50 and 300 $\mu$s and the basic value of current between the pulses is kept within the range from 5 to 15 A per one square decimetre of the circuit board, whereafter the pulse-width modulation is ended, the pulse length is adjusted to a value between 10 and 100 $\mu$s and the basic value of current between the pulses is kept within the range from 0 to 15 A per one square decimetre.

The method of the invention is based on the idea that, as compared with vacuum values conventionally used in the magnetron sputtering equipment, the pressure in the vacuum chamber need not be so low as generally believed but it can be considerably higher when the circuit board is disposed relatively close to the cathode of the vacuum chamber unit and is continuously flushed with an inert gas. At the same time, the problems caused by the impurities emitted by the circuit board material are eliminated. The method of the invention is further based on the idea to use a pulse galvanizing technique known per se (e.g. US Patent 4,496,436) after the plasma coating.

The most important advantages of the method of the invention are that it is rapid; it can be realized with a small and light apparatus advantageous in structure and production costs; and it provides an even electrically conductive layer. The apparatus applying the method can be made ready for operation in a few minutes.

In the method of the invention, a very thin conductive layer, about 0.5 to 10 $\mu$m in thickness, is formed and its thickness is increased by pulse galvanizing. In plasma coating, the aim is to form a layer as thin as possible, as the adherence of a thin layer to the basic material is good. As is well-known, a thin layer is, however, almost impossible to grow galvanically by DC current in the conventional way due to its high electric resistance. The pulse galvanizing technique used in the method of the invention is especially developed to be applied as further treatment after the magnetron sputtering technique and it enables an electrically conductive layer to be grown successfully.

A vacuum chamber unit of the invention is mainly characterized in that the vacuum chamber is substantially flat in shape and its both side surfaces are provided with an opening for said magnet-cathode-anode units and that both magnet-cathode-anode units are formed by a sandwich structure. The most important advantages of the vacuum chamber unit over the vacuum chamber units of the prior art are that it has a small volume due to its flat shape, so that the required vacuum can be very rapidly created in it, and it is easy to flush with an inert gas to remove the impurities of the remaining gases; two magnet-cathode-anode units can be easily disposed in it at a desired, relatively small distance from the circuit board to be coated, in addition to which the flat shape facilitates the coating of the circuit board on both sides in a single step. It is also easy from the structural point of view to provide a retaining member supporting the circuit board in the flat vacuum chamber. This retaining member is inserted in a cartridge-like manner automatically within the vacuum chamber and is removed after coating. Being of sandwich structure, the magnet-cathode-anode units are easy to manufacture. They need not be manufactured by laboriously milling from large bodies, as previously, but the sandwich structure enables even very large magnet-cathode-anode units to be manufactured in which the required insulations between the different parts are easy to realize.

In the following the invention will be described in detail by means of its one preferred embodiment with reference to the attached drawings, in which

Figure 1 is a general view of an apparatus by means of which the method of the invention can be applied;

Figure 2 illustrates a vacuum chamber in the apparatus of Figure 1;

Figure 3 shows a circuit board rack suitable for use in the vacuum chamber of Figure 2;

Figures 4 to 6 illustrate a magnet-cathode-anode unit to be attached to the vacuum chamber unit of the invention; and

Figures 7 and 8 illustrate the structure of the magnet.

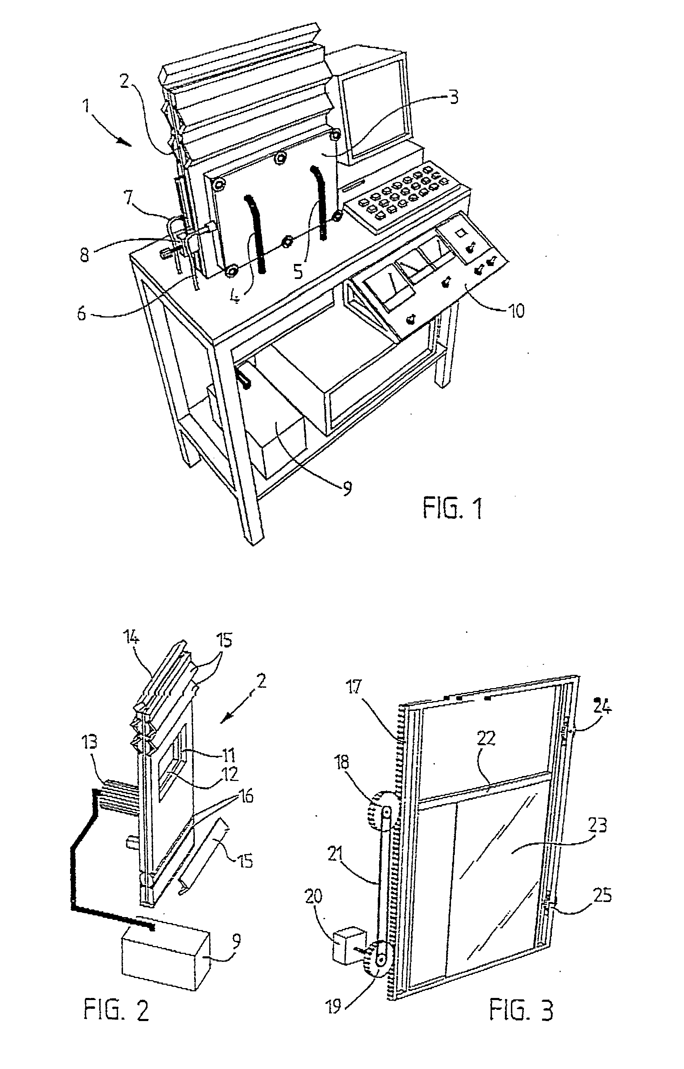

Figure 1 shows an apparatus used in the manufacture of circuit boards, comprising a vacuum chamber unit according to the invention. The vacuum chamber unit, generally indicated with the reference numeral 1, comprises a vacuum chamber 2 and two identical magnet-cathode-anode units 3 detachably attached to the vacuum chamber (in the figure, only the foremost unit is visible). The reference numerals 4 and 5 indicate cooling pipes for cooling the cathode of the magnet-cathode-anode unit. Warm water is used as coolant. Cooling is necessary as otherwise the cathode melts locally adjacent to the plasma ring to be formed. Electricity is supplied through conductors 6 and 7 to both magnet-cathode-anode units 3 in such a way that a required potential is formed between the cathode and the anode. The anode is in direct electrical contact with the vacuum chamber frame. The reference numeral 8 indicates means for introducing argon gas, comprising a needle valve for accurate adjustment of the amount of gas. The reference numeral 9 indicates a pump which is used when creating a required vacuum in the vacuum chamber 2 for the plasma sputtering. A control unit monitoring the operation of the apparatus, comprising meters indicating pressure and electric power, are indicated with the reference numeral 10.

Figure 2 shows the vacuum chamber 2 of the vacuum chamber unit of the invention. As clearly appears from the figure, the vacuum chamber 2 is flat in shape and its both side surfaces are provided with an opening 11, 12 to which the magnet-cathode-anode units are attached. It further appears from Figure 2 that two pumps 9 and 13 are connected in series in the vacuum chamber for creating a desired vacuum in the vacuum chamber 2. The upper end of the vacuum chamber 2 is provided with a gap for inserting a circuit board into the vacuum chamber. The gap is closeable by means of a cover 14.

Due to its flat shape, the vacuum chamber 2 is very liable to collapse when vacuum with respect to the ambient atmospheric pressure is created in its inner space. Therefore the side surfaces of the vacuum chamber 2 are provided with support profiles 15 for reinforcing the vacuum chamber. The support profiles are disposed in grooves 16 formed in the side surfaces of the vacuum chamber. The support profiles 15 are easy and rapid to fix in position. As compared with fixing with screws, fixing in grooves gives a better and firmer end result. In addition, the groove arrangement has cheaper manufacturing costs than the screw arrangement.

Figure 3 shows a detachable circuit board rack suitable for use in the flat vacuum chamber of Figure 2. The circuit board rack is framework-like as it is intended to be displaced within the vacuum chamber. The circuit board rack, shown in Figure 3 on a larger scale than the vacuum chamber 2 of Figure 2, comprises a toothing 17 on its one edge. The toothing is arranged to interact with displacing rolls 18, 19 provided with a toothed ring and disposed close to one longitudinal edge of the vacuum chamber. The lower displacing roll 19 is operated by a motor 20 and the displacing rolls are interconnected by means of an endless band 21. The motor 20 is disposed outside the vacuum chamber 2. The circuit board rack comprises a cleat 22 preferably U-shaped in cross-section. The cleat 22 is displaceable in the plane of the circuit board rack in such a way that the groove of the cleat can be positioned against the edge of the circuit board 23. The edge opposite to the toothed edge of the circuit board rack is provided with two rolls 24, 25 which enable the circuit board rack to be displaced in the vacuum chamber 2 with a low friction. As distinct from Figure 3, the band can advantageously be arranged to extend over the rolls 18 and 19, whereby it is toothed on its both sides. This solution enables the circuit board rack to be guided very smoothly.

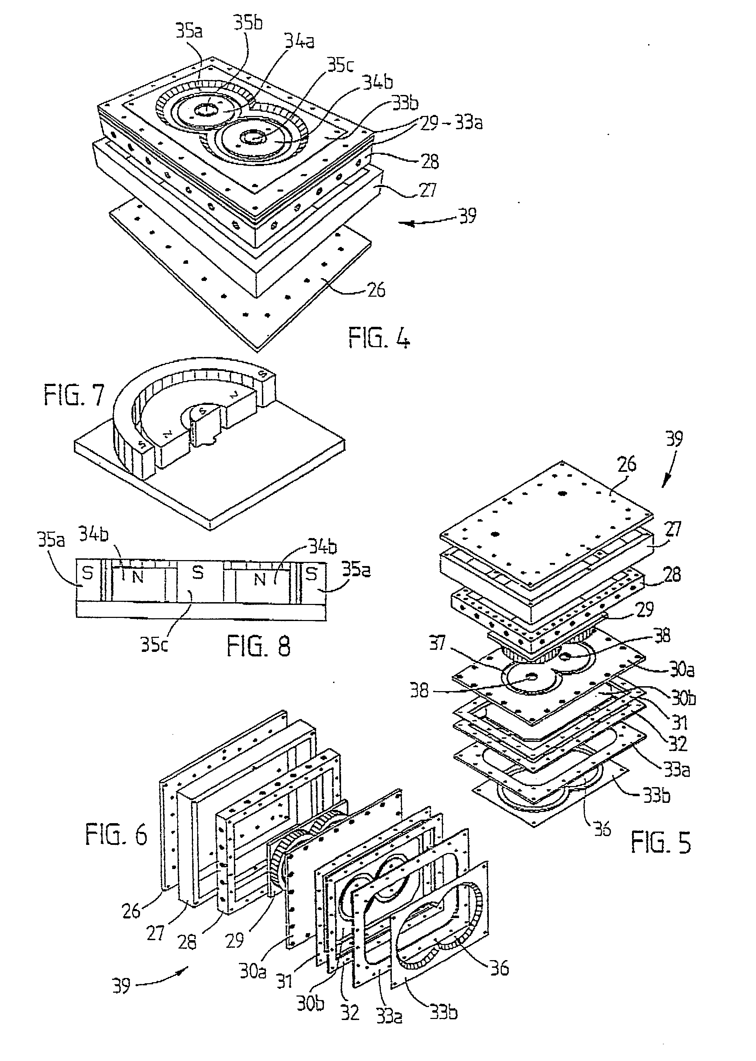

Figures 4 to 6 show one preferred magnet-cathode-anode unit 39 to be used in the vacuum chamber unit of the invention. The magnet-cathode-anode unit 39 is formed into a sandwich structure comprising several layers, because it is considerably cheaper to manufacture than a magnet-cathode-anode unit formed by about three parts only, which require laborious machining steps. The plates of the sandwich-structure magnet-cathode-anode unit 39 are kept together by a number of screws (not shown in Figures 4 to 6). Holes are provided for the screws in the edges of the layers of the magnet-cathode-anode unit. In Figures 4 to 6, the reference numerals 26 to 35 refer to the following components: 26 is a back plate; 27 is a protective cover; 28 is a body casing; 29 is a magnet; 30a is a cathode; 30b is a target; 31 is a VITON$^R$ seal; 32 is a TEFLON$^R$ seal; 33a is an anode; and 33b is an anode ring. The target 30b is that portion of the cathode from which material is separated into plasma form when applying the method.

It appears from Figures 4 to 6 that the magnetic north of the magnet part is formed by two rings 34a, 34b positioned side by side and surrounded by an outer 8-shaped magnetic south portion 35a, whereby inner magnetic south portions 35b and 35c are fitted centrally within both rings 34a, 34b of the magnetic north. It is preferable that the magnetic south 35, when embedded in the cathode 30a, penetrates closer to the target 30b than the magnetic north 34a, 34b, because a symmetric plasma ring is obtained in this way without having to provide the outer magnetic south 35a with an equally broad magnet than in the magnetic north 34b. The narrow outer magnetic south portion is advantageous to manufacture as it saves material, cf. Figures 7 and 8. In this arrangement, the cathode 30a comprises an 8-shaped groove 37 for the 8-shaped outer magnetic south portion 35a of the magnet, and grooves 38 for the inner magnetic south portions 35b and 35c. It appears from Figures 4 to 6 that the anode of the magnet-cathode-anode unit 39 comprises an anode ring 33b provided with a substantially 8-shaped opening 36. The inner edges of the opening 36 are bevelled towards the centre of the vacuum chamber unit. The edge of the anode ring 33b is bevelled because the metal sputtered thereon it may scale off and enter between the target 30b and the anode ring, thus causing a short circuit. From the bevelled surface, possible metal particles fall off to the bottom of the vacuum chamber 2 and do not cause a short circuit in the narrow (about 2 mm) gap between the anode ring 33b and the target 30b. As distinct from the above, the order of the magnetic poles may be reversed while the influence of the magnet remains unchanged. Accordingly, in Figures 4 to 6, the magnetic north may be the part 35 and the magnetic south may be the part 34.

In the following, the method of the invention will be described in short with reference to the use of the apparatus of Figure 1. The circuit board 23 to be coated is placed in the circuit board rack of Figure 3. Circuit boards to be coated can be loaded in one or more frames outside the vacuum chamber 2, so that this step need not be carried out in an unpleasant working position above the vacuum chamber. The cover of the vacuum chamber 2 is opened and the circuit board rack is displaced into the chamber 2 through the gap. The cover 14 is closed and a vacuum of 0.015 to 0.1 mb, preferably 0.05 to 0.1 mb, is created in the vacuum chamber 2. When the circuit board rack is inserted into the vacuum chamber 2, it strikes against the displacing rolls 18, 19, which transport the rack in a desired manner up and down in the chamber. When the circuit board rack is displaced downwards, it is kept at a distance of 5 to 70 mm, preferably 20 to 50 mm, from the cathode of the magnet-cathode-anode unit. After the circuit board 23 has been passed onto the bottom of the vacuum chamber 2, the plasma cloud generated in the vacuum chamber by means of the electric and magnetic field has coated the circuit board on both sides with an electrically conductive layer, and it can be lifted away from the vacuum chamber. The plasma coating also extends inside possible holes in the circuit board. The formed circuit board or circuit board blank is further coated with a galvanic pulse galvanizing method. In pulse galvanization, the sputtered circuit board is exposed to a current density of 40 to 80 A per one square decimetre of the circuit board, and pulse-width modulation is applied at a pulse frequency of 500 Hz to 10 kHz, a modulation frequency of 10 to 50 Hz being applied for 20 to 80 seconds. During the pulse-width modulation, the pulse width is varied between 50 and 300 $\mu$s and the basic value of current between the pulses is kept within the range from 5 to 15 A per one square decimetre of the circuit board, whereafter the pulse-width modulation is ended, the pulse length is adjusted to a value between 10 and 100 $\mu$s and the basic value of the current between the pulses is kept within the range from 0 to 15 A per one square decimetre until the desired layer thickness is achieved.

The invention has been described above by means of example. It is to be understood that the details of the invention may deviate in various way from the above within the scope of the attached claims. Accordingly, the inert gas need not be argon but some other inert gas may be used as well. Even though it is disclosed above that the magnet-cathode-anode unit of the vacuum chamber unit comprises two magnet rings positioned side by side, there may be provided several rings side by side in cases where a broad magnetic field is required. The method and the apparatus of the invention can be advantageously applied in the production of multi-layer circuit boards.

The invention relates to a method of producing circuit boards by utilizing a magnetron sputtering method, in which a circuit board (23) is placed in a chamber (2) to which a magnet-cathode-anode unit (3) is attached, vacuum is created in the chamber and inert gas is introduced into it and a plasma cloud is formed in it by means of an electric and magnetic field, whereby metal atoms break away from the cathode (30) and deposit on the surface of the circuit board (23). In order that the coating process would be technically easy and provide a good coating result, the method of the invention is mainly characterized in that the circuit board (23) is kept at a pressure of 0.015 to 0.1 mb at a distance of 5 to 70 mm from the cathode (30) of the magnet-cathode-anode unit during the plasma coating, whereafter the circuit board (23) is coated galvanically by a pulse galvanization technique. The invention is also concerned with a vacuum chamber unit for use in the production of circuit boards.

## Claims

1. Method of producing a circuit board by utilizing a magnetron sputtering technique, in which a circuit board (23) is placed in a chamber (2) to which a magnet-cathode-anode unit (3) is attached, vacuum is created in the chamber and inert gas is introduced into it and a plasma cloud is formed in it by means of an electric and magnetic field, whereby metal atoms break away from the cathode (30) and deposit on the surface of the circuit board (23), **characterized** in that the circuit board (23) disposed in the chamber (2) is kept at a pressure of 0.015 to 0.1 mb at a distance of 5 to 70 mm from the cathode (30) of the magnet-cathode-anode unit during the plasma coating, whereafter the circuit board (23) is coated galvanically by a pulse galvanization technique at a current density of 40 to 80 A per one square decimetre of the circuit board, and pulse-width modulation is applied at a pulse density of 500 Hz to 10 kHz, and a modulation frequency of 10 to 50 Hz is applied for 20 to 80 seconds, whereby the pulse width is varied during the pulse-width modulation between 50 and 300 $\mu$s and the basic value of current between the pulses is kept within the range from 5 to 15 A per one square decimetre of the circuit board, whereafter the pulse-width modulation is ended, the pulse length is adjusted to a value between 10 and 100 $\mu$s and the basic value of current between the pulses is kept within the range from 0 to 15 A per one square decimetre.

2. Method according to claim 1, **characterized** in that the circuit board (23) placed in the chamber (2) is kept during the plasma coating at a pressure of 0.05 to 0.1 mb and at a distance of 20 to 50 mm from the cathode (30) of the magnet-cathode-anode unit.

3. Vacuum chamber unit for use in the production of circuit boards by utilizing a magnetron sputtering technique, the vacuum chamber unit (1) comprising a vacuum chamber (2) to which two magnet-cathode-anode units (3) are attached detachably, **characterized** in that the vacuum chamber (2) is substantially flat in shape and its both side surfaces are provided with an opening (11, 12) for said magnet-cathode-anode units (3) and that both magnet-cathode-anode units (3) are formed by a sandwich structure.

4. Vacuum chamber unit according to claim 3, **characterized** in that when embedded in the cathode (30a), one pole (35) of the magnet (29) penetrates closer to a target (30b) than the opposite pole (34a, 34b) of the magnet.

5. Vacuum chamber unit according to claim 3 or 4, **characterized** in that the other pole (34) of the magnet (29) is formed by two rings (34a, 34b) positioned side by side and surrounded by the outer 8-shaped opposite magnet pole (35a), whereby the inner opposite pole portions (35b, 35c) are fitted centrally within said rings.

6. Vacuum chamber unit according to claim 5, **characterized** in that the cathode (30a) of both magnet-cathode-anode units (3) comprises an 8-shaped groove (37) for the 8-shaped outer pole portion (35a) of the magnet (29), and grooves (38) for the inner pole portions (35b, 35c).

7. Vacuum chamber unit according to claim 6, **characterized** in that the anode (30) of both magnet-cathode-anode units (3) comprises a substantially 8-shaped opening (36) the inner edges of which are bevelled towards the centre of the vacuum chamber unit (1).

8. Vacuum chamber unit according to claim 3, comprising a circuit board rack having a retaining member (22) for keeping a circuit board (23) in positioned in the circuit board rack, **characterized** in that the circuit board rack is a framework-like detachable unit, and the vacuum chamber unit (1) comprises displacing means (17 to 20) for displacing the circuit board rack into the vacuum chamber (2) and away from it.

9. Vacuum chamber unit according to claim 8, **characterized** in that the displacing means (17 to 20) comprises displacing rolls (18, 19) positioned on one edge of the vacuum chamber (2) and interacting with a toothing (17) or the like provided on one edge of the circuit board rack, and that the retaining member comprises a grooved, preferably U-shaped cleat (22) which is displaceable in the plane of the framework-like circuit board rack in such a way that the groove of the cleat is arranged to be positioned against the edge of the circuit board (23).

FIG. 1

FIG. 2

FIG. 3

FIG. 4

FIG. 7

FIG. 8

FIG. 6

FIG. 5